# DEMANDE DE BREVET EUROPEEN

(11) **EP 1 014 447 A1**
(43) Date de publication de la demande: **28.06.2000**
(21) Numéro de dépôt: 99410185.5
(22) Date de dépôt: 22.12.1999
(51) Int. Cl.: H01L 27/07, H01L 27/115, G11C 11/404, H01L 21/8247

(54) **Cellule mémoire à programmation unique en technologie CMOS**

(30) Priorité: 23.12.1998 FR 9816582
(71) Demandeur: STMicroelectronics S.A., 94250 Gentilly (FR)
(72) Inventeur: Candelier, Philippe, 38190 Saint Mury Monteymond (FR); Schoellkopf, Jean-Pierre, 38000 Grenoble (FR)
(74) Mandataire: de Beaumont, Michel

(57) **Abrégé**

L'invention concerne une cellule mémoire à programmation unique en technologie CMOS, comprenant une capacité (C) associée en série avec un transistor (T) de programmation dissymétrique, dont le drain est formé d'une région plus faiblement dopée et plus épaisse que la source.

## Description

La présente invention concerne le domaine des cellules mémoire non volatiles à programmation unique (OTP), qui sont susceptibles de conserver un état programmé même après disparition de l'alimentation du circuit. L'invention concerne, plus particulièrement, une telle cellule mémoire réalisée à partir d'une capacité d'oxyde.

Un exemple d'application des cellules à programmation unique est la réalisation d'éléments de redondance qui sont généralement prévus dans des mémoires réalisées sous la forme d'un ou plusieurs réseaux matriciels en circuit intégré, pour remplacer fonctionnellement un élément de mémoire défaillant. Le rôle des cellules à programmation unique est alors de programmer le décalage des colonnes ou rangées de la mémoire lors de l'utilisation d'un des éléments de redondance pour pallier la défaillance d'une colonne ou d'une rangée du réseau.

Dans ce genre d'application, on utilise soit des éléments fusibles, par exemple par laser, soit des cellules mémoire à programmation unique du type EEPROM, ou du type à transistor à grille flottante. Toutes ces structures classiques ont pour inconvénient majeur de ne pas être compatibles avec de simples procédés de fabrication CMOS. En particulier, des cellules mémoire non volatiles de type EPROM requièrent deux épaisseurs d'oxyde de grille alors qu'un procédé de fabrication CMOS standard n'en utilise qu'une.

Dans un procédé CMOS standard, on dépose, après la formation, dans un substrat de silicium, de régions de source et de drain de transistors MOS à canal P et à canal N, une seule couche d'oxyde (généralement, d'oxyde de silicium) et une seule couche de silicium polycristallin pour former les grilles des transistors avant les niveaux de métallisation.

On connaît également des structures de fusible en silicium polycristallin qui nécessitent cependant un fort courant de programmation pour obtenir la fusion (de l'ordre de 100 mA).

La catégorie de cellules mémoire à programmation unique à laquelle se rapporte la présente invention est généralement désignée par structure "anti-fusible" dans la mesure où l'état non programmé de la cellule est un état d'isolement de deux électrodes et que son état programmé est un état de passage du courant. Il s'agit, plus particulièrement, de cellules formées d'une capacité constituée d'une épaisseur d'oxyde susceptible d'être rendu conducteur (claqué) après application d'une surtension entre les deux électrodes de la capacité.

Un problème qui se pose pour la réalisation d'une telle structure à claquage d'oxyde avec un procédé CMOS standard est lié à la commutation de la haute tension requise pour claquer les capacités. En effet, les transistors standards ne peuvent pas commuter cette haute tension sans être, eux-mêmes, en régime de claquage.

Par exemple, dans une technologie où la dimension minimale d'un motif de masque est de 0,25 µm, la tension d'alimentation des circuits CMOS est généralement de l'ordre de 2,5 V alors qu'une cellule à programmation unique à claquage d'oxyde requiert de l'ordre de 10 V pour un oxyde ayant une épaisseur de l'ordre de 5 nm qui constitue l'épaisseur habituelle de l'oxyde de grille dans cette technologie.

Si une telle tension de 10 V est généralement disponible sur les cartes de circuit intégré auxquelles sont destinés les circuits intégrés de mémoires, cette tension n'est pas compatible avec les structures de sélection d'adressage et les étages d'entrée-sortie des mémoires dont la tension de fonctionnement est liée au procédé CMOS utilisé.

Le document US-A-4943538 décrit une cellule mémoire anti-fusible dans laquelle plusieurs niveaux d'oxyde sont nécessaires, et qui n'est donc pas réalisable sans ajouter d'étape par rapport à un procédé CMOS classique n'utilisant qu'un seul niveau d'oxyde.

Les documents US-A-5324681 et EP-A-0528417 décrivent des cellules mémoire anti-fusibles basées sur un procédé de fabrication de DRAM à deux oxydes (l'oxyde CMOS et l'oxyde des capacités DRAM qui est de plus faible épaisseur pour être claquable avec un transistor standard). Il est donc nécessaire d'ajouter des étapes par rapport à un procédé CMOS classique.

La présente invention vise à proposer une nouvelle cellule mémoire à programmation unique du type à claquage d'oxyde qui soit compatible avec un simple procédé de fabrication CMOS. En particulier, la présente invention vise à proposer une solution qui ne nécessite qu'un seul niveau d'oxyde de grille dans le procédé de fabrication.

La présente invention vise également à ce que les cellules mémoires puissent être fabriquées sans étape supplémentaire par rapport à un procédé CMOS classique.

Pour atteindre ces objets, la présente invention prévoit une cellule mémoire à programmation unique en technologie CMOS, comprenant une capacité associée en série avec un transistor de programmation dissymétrique, dont le drain est formé d'une région plus faiblement dopée et plus épaisse que la source.

Selon un mode de réalisation de la présente invention, cette association en série est connectée entre deux bornes d'application d'une tension d'alimentation.

Selon un mode de réalisation de la présente invention, une première électrode de la capacité est constituée par ladite région.

Selon un mode de réalisation de la présente invention, la capacité est formée dans un niveau d'oxyde constitutif de grilles de transistors.

Selon un mode de réalisation de la présente invention, une deuxième électrode de la capacité est propre à recevoir, en lecture, un potentiel relativement bas et, en programmation, un potentiel relativement élevé.

Selon un mode de réalisation de la présente invention, le transistor et la capacité sont dimensionnés de sorte que, pendant un cycle de programmation et pour une cellule non sélectionnée, la tension aux bornes de la capacité reste inférieure à sa tension de claquage quand les courants dans la capacité et dans le transistor s'équilibrent.

Selon un mode de réalisation de la présente invention, le transistor est dimensionné pour limiter le courant dans une cellule sélectionnée, tout en autorisant un claquage de l'oxyde constitutif de la capacité.

La présente invention prévoit également un procédé de fabrication de cellules mémoire à programmation unique de type anti-fusible, dans lequel les régions de drains des transistors de programmation dissymétriques d'un premier type de canal sont formées en même temps que des caissons destinés à recevoir des transistors MOS d'un deuxième type de canal.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente, de façon schématique, un mode de réalisation d'une cellule mémoire à programmation unique selon la présente invention ;
la figure 2 est une coupe d'une cellule mémoire selon l'invention, réalisée en circuit intégré ;
la figure 3 illustre la programmation d'une cellule selon la présente invention ;
la figure 4 illustre les critères de dimensionnement d'une capacité et du transistor de programmation d'une cellule mémoire selon la présente invention ; et
la figure 5 est un exemple de circuit de lecture différentiel de cellules mémoire à programmation unique selon la présente invention.

Les mêmes éléments ont été désignés par les mêmes références aux différentes figures. Par souci de clarté, seuls les éléments qui sont nécessaires à la compréhension de l'invention ont été représentés aux figures et seront décrits par la suite.

Une caractéristique de la présente invention est d'associer, en technologie CMOS, une capacité en oxyde en série avec un transistor de programmation pour constituer une cellule mémoire non volatile.

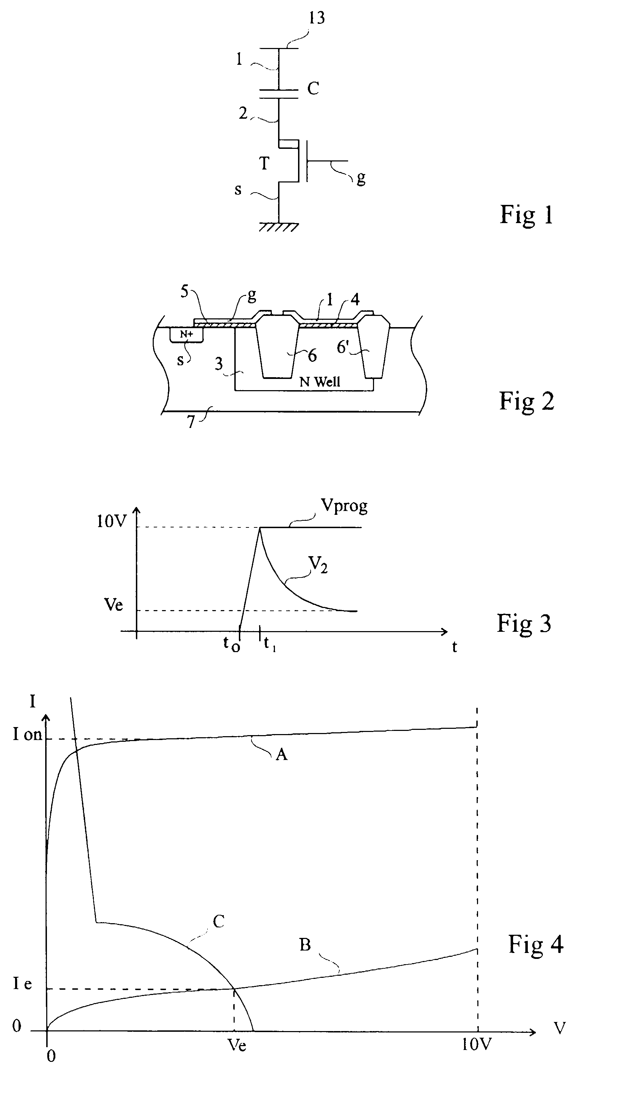

La figure 1 représente le schéma électrique d'une cellule mémoire non volatile selon la présente invention. La capacité d'oxyde C a une borne 1 propre à être connectée à une borne plus positive d'alimentation et une borne 2 constituant un point d'interconnexion avec le drain d d'un transistor MOS T de programmation dont la source s est connectée à une borne plus négative d'alimentation (généralement, la masse).

Selon la présente invention, le transistor T est un transistor dissymétrique dont le drain est formé d'une région plus faiblement dopée et plus épaisse que la source. De préférence, on utilise l'étape de formation de caissons de même type de conductivité que le canal pour former le drain, la source restant formée par une région plus réduite (que le drain) comme les sources et drains des autres transistors du circuit intégré CMOS classique. Ainsi, dans l'exemple représenté où le transistor T est un transistor NMOS, le drain de ce transistor est formé d'une région profonde de type N. La figure 2 est une vue en coupe schématique d'un tel transistor. Le drain du transistor NMOS y est symbolisé par un caisson N (NWell) référencé 3. La cellule mémoire de l'invention telle que représentée à la figure 2 comporte donc, par exemple à partir d'un substrat 7 de type P, un caisson N destiné à former non seulement le drain du transistor T mais également une première électrode 2 de la capacité C. Le recours à un tel transistor dissymétrique dont le drain est formé d'un "caisson" permet d'appliquer une tension plus élevée sur le drain du transistor sans l'endommager. Ce type de transistor est généralement désigné par son appellation anglo-saxonne "DRIFT MOS".

Selon l'invention, la réalisation d'un tel transistor dissymétrique ne requiert pas d'étape supplémentaire par rapport au procédé CMOS classique. En effet, des caissons sont classiquement formés pour loger les transistors ayant un canal de même type que le substrat. Ainsi, un avantage de la présente invention est que la réalisation des transistors de programmation (qui doivent tenir une tension plus élevée que les transistors CMOS du reste du circuit comme on le verra par la suite) s'effectue au moyen du motif du masque de réalisation des caissons (par exemple N, si le substrat est de type P) dans lesquels sont formés les transistors de canal de même type que le substrat, afin d'y prévoir les drains des transistors dissymétriques.

Comme l'illustre la figure 2, la capacité C est constituée d'une région d'oxyde 4 formée dans le même oxyde que l'oxyde 5 de grille g des transistors. Une couche de silicium polycristallin rapportée sur la couche d'oxyde permet de former la deuxième électrode 1 de la capacité C ainsi que l'électrode g de grille du transistor T.

Dans l'exemple de la figure 2, la région 4 d'oxyde de la capacité C est séparée de la région 5 d'oxyde de grille et des dispositifs voisins (non représentés) par deux tranchées d'isolation latérale 6 et 6' remplies d'oxyde. Les tranchées 6 et 6' participent notamment à créer la résistance d'accès au transistor. La région faiblement dopée 3 s'étend de part et d'autre de la région 6, et sous celle-ci, et s'arrête au niveau de la région 6', la région 6 séparant, en surface, les régions 4 et 5.

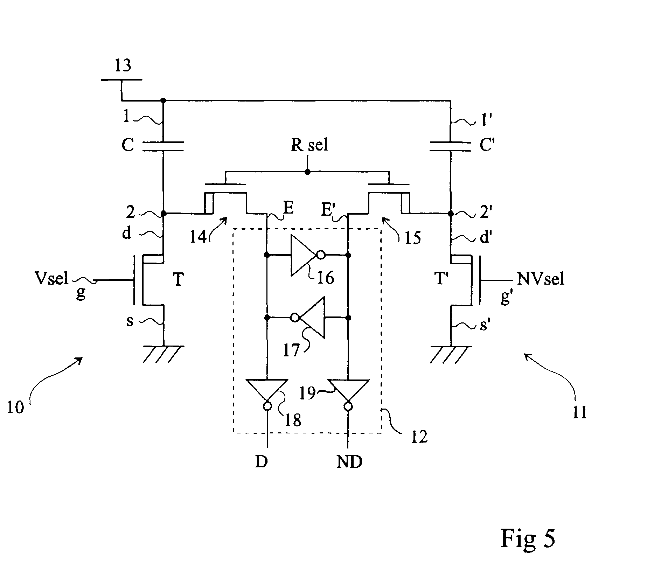

Le cas échéant, on peut prévoir, dans le caisson 3, une région (non représentée) plus fortement dopée (N+) que le caisson 3, c'est-à-dire dopée par exemple comme la région s. Cette région a alors pour rôle de permettre une prise de contact au drain du transistor T, donc au noeud 2 de mémorisation de la cellule. On notera toutefois qu'une telle prise de contact est facultative. En effet, le caisson 3 peut également constituer le caisson de drain d'un transistor MOS à canal N d'un circuit de lecture comme on le verra par la suite en relation avec la figure 5, auquel cas aucune prise de contact n'est nécessaire.

On notera également que la représentation de la figure 2 est schématique et symbolique. En particulier, la capacité pourra, par exemple, être séparée du transistor T par un anneau de garde en oxyde épais. Dans ce cas, la connexion entre l'électrode 2 et le drain du transistor T sera effectuée par un niveau de métallisation supérieur.

Le rôle du transistor T est de permettre la sélection, pour programmation, de la cellule mémoire ainsi constituée en provoquant le claquage de l'oxyde de grille 4 de la capacité afin de rendre la cellule (anti-fusible) conductrice.

Selon la présente invention, un cycle de programmation d'une cellule mémoire illustrée par les figures 1 et 2, s'effectue en trois étapes principales.

Dans une première étape, on sélectionne la cellule concernée au moyen du transistor T de cette cellule, en portant sa grille g à un potentiel Vdd (par exemple, 2,5 V) correspondant au potentiel d'un circuit logique CMOS.

Dans une deuxième étape, on applique une rampe de tension Vprog (par exemple de 0 à 10 V en quelques centaines de millisecondes) sur l'électrode 1 de programmation de la capacité.

La rampe de tension Vprog provoque le claquage de l'oxyde 4 de la capacité C. Lors de ce claquage, le transistor T dont le drain est formé par le caisson 3 limite le courant entre l'électrode 1 de la capacité et la source s du transistor T.

Comme une cellule mémoire selon l'invention est généralement contenue dans un réseau matriciel dans lequel on choisit de sélectionner une ou plusieurs cellules telles qu'illustrées par les figures 1 et 2, seules les cellules sélectionnées doivent être programmées alors que l'échelon de tension Vprog est appliqué sur toutes les cellules.

Par conséquent, lors de la programmation d'un réseau de cellules mémoire à programmation unique selon l'invention, les cellules non sélectionnées par leurs transistors T respectifs ne doivent pas voir l'oxyde de leurs capacités respectives claquer lors de l'application de la rampe de tension Vprog.

Dans l'hypothèse où une cellule mémoire n'est pas sélectionnée, la grille g de son transistor est à l'état bas de la logique CMOS, par exemple 0 V. Par conséquent, au début de la rampe de programmation, on suppose que la capacité C n'est pas chargée. On a donc une tension de 10 V aux bornes du transistor T et une tension nulle aux bornes de la capacité C. Il en découle un courant de fuite Ioff circulant dans le transistor T qui charge le noeud 2 de la cellule jusqu'à atteindre un équilibre entre le courant dans le transistor T et le courant dans la capacité C.

Ce phénomène est illustré par la figure 3 qui représente, sous forme de chronogramme, l'évolution du potentiel au noeud 2 d'interconnexion entre la capacité C et le transistor T lors de l'application d'un échelon ou rampe de tension de programmation Vprog alors que la cellule n'est pas sélectionnée.

La rampe de tension Vprog est appliquée entre des instants t0 et t1. Entre ces instants, l'allure du potentiel V2 au point 2 suit la tension Vprog (la tension aux bornes de la capacité C étant nulle). A l'instant t1 où la tension Vprog atteint son maximum (par exemple, 10 V), le potentiel V2 de la borne 2 se met à décroître jusqu'à ce que le courant dans le transistor T atteigne le courant dans la capacité C. Cette tension Ve constitue le point d'équilibre d'une cellule mémoire non programmée selon l'invention.

La capacité C et le transistor T d'une cellule mémoire de l'invention sont dimensionnés de sorte que le point d'équilibre (courant dans la capacité C = courant dans le transistor T) soit tel que la différence de potentiel aux bornes de la capacité C reste inférieure à sa tension de claquage. Cette condition garantit le maintien dans un état non programmé d'une cellule qui n'est pas sélectionnée.

La figure 4 illustre la caractéristique du point d'équilibre Ve selon la présente invention dans l'association d'une capacité et d'un transistor dissymétrique. Cette figure représente plusieurs caractéristiques courant-tension d'une cellule mémoire de l'invention.

Une première courbe A donne le courant dans le transistor T d'une cellule sélectionnée. Ce courant Ion croît brusquement pour atteindre une valeur asymptotique élevée alors que la tension de grille du transistor T est, par exemple, de 2,5 V.

Une deuxième courbe B illustre le courant de fuite dans le transistor T pour une cellule non sélectionnée, c'est-à-dire dont la grille est au même potentiel que sa source. Dans ce cas, le courant de fuite Ioff croît avec l'augmentation de la tension aux bornes du transistor.

Une troisième courbe C illustre l'allure du courant dans la capacité C. Par souci de clarté, cette courbe a été représentée avec les courbes A et B, mais on notera que son échelle de tension est inversée. Ainsi, cette courbe C indique un début de conduction de type "Fowler Nordheim" pour une tension de l'ordre de 5 V. Le courant dans la capacité augmente alors avec le champ électrique jusqu'au claquage (point d'inflexion de la courbe C) qui se produit pour une tension de l'ordre de 9 V.

On constate que la courbe C coupe les courbes A et B. L'intersection entre la courbe A et la courbe C représente le point de claquage de l'oxyde de la capacité lors de la programmation d'une cellule sélectionnée. L'intersection entre la courbe B et la courbe C indique le point d'équilibre (Ie, Ve) d'une cellule non sélectionnée.

Selon la présente invention, on choisira les dimensions respectives du transistor T et de la capacité C pour respecter, de préférence simultanément, les conditions suivantes :
1) pour les transistors T, disposer d'un rapport largeur sur longueur de grille tel que le courant de fuite Ioff soit minimal. On cherchera toutefois un compromis pour maintenir un courant de lecture suffisant. En effet, plus le courant Ion est élevé, plus la résistance de l'oxyde de la capacité sera faible une fois claquée.
2) Pour la capacité C, on recherchera un compromis entre une taille la plus faible possible pour minimiser la densité des cellules de l'invention mais suffisante pour obtenir une tension aux bornes de la capacité la plus faible possible au point d'équilibre afin de ne pas claquer les cellules qui ne sont pas sélectionnées.

A titre d'exemple particulier de réalisation, une cellule mémoire selon l'invention pourra être réalisée, en technologie 0,25 µm, en utilisant des transistors T dont les rapports largeur/longueur de grille seront compris entre 0,5 et 5 et, de préférence, proches de 1. Les surfaces des capacités C seront comprises, par exemple, entre 0,2 µm² et 50 µm², de préférence, de l'ordre de 25 µm².

On notera qu'une cellule à programmation unique selon l'invention est parfaitement compatible avec l'utilisation d'un schéma électrique classique pour réaliser les structures d'adressage en lecture. Toutefois, dans le mode de réalisation décrit ci-dessus (caisson de type N), la lecture s'effectuera de préférence en accumulation, c'est-à-dire avec une tension de grille positive. En d'autres termes, on cherchera à effectuer la lecture alors que la tension de l'électrode 1 est positive et est supérieure à la tension du drain 3, ceci afin de disposer d'un courant suffisant en lecture.

La figure 5 représente un mode de réalisation d'une architecture de cellule complète, comprenant un étage de lecture différentiel, et réalisée à partir d'une structure de cellules mémoire telle qu'illustrée par les figures 1 et 2.

Ainsi, s'agissant d'une structure différentielle, deux cellules mémoire 10, 11 sont représentées en figure 5 et utilisent un même amplificateur de lecture ou circuit 12 logique de sortie. Les condensateurs C et C' des cellules ont chacun leur borne 1, 1' connectée à une borne commune 13 d'application d'un potentiel le plus positif. Selon l'invention, le potentiel appliqué à la borne 13 est la tension Vprog pendant la programmation et la tension Vdd pendant les cycles de lecture.

Les bornes respectives 2, 2' des condensateurs C, C' sont connectées aux drains respectifs d, d' des transistors T, T' de programmation des cellules concernées. Les sources s, s' des transistors T, T' sont connectées à la masse et leurs grilles respectives reçoivent des signaux de sélection Vsel et NVsel.

Pour opérer la lecture d'une cellule, les noeuds respectifs 2 et 2' sont connectés, chacun par l'intermédiaire d'un transistor NMOS 14, 15, à des entrées respectives E, E' du circuit logique de lecture 12. Les grilles respectives des transistors 14 et 15 reçoivent un signal de commande de lecture RSel lorsqu'un transfert des données mémorisées par les cellules 10 et 11 est requis.

Le circuit 12 de lecture est, de façon classique pour un système de lecture différentiel, constitué de deux inverseurs 16, 17 connectés en antiparallèle entre les bornes E et E'. La borne E est par ailleurs reliée à l'entrée d'un amplificateur-inverseur de sortie 18 délivrant la donnée lue D. La borne E' est connectée à l'entrée d'un amplificateur-inverseur 19 dont la borne de sortie délivre la donnée lue complémentée ND.

Le fonctionnement d'un circuit logique de décodage différentiel tel qu'illustré par la figure 5 est parfaitement connu. Il est toutefois ici appliqué à des cellules à programmation unique selon l'invention. On rappellera simplement que, s'agissant d'une lecture différentielle, une des cellules 10 ou 11 sert de référence pour la lecture de l'autre, de sorte que la programmation des cellules doit tenir compte du besoin de complémentarité des cellules appariées.

Pour protéger le circuit logique de lecture 12 (constitué à partir de transistors CMOS) lors de la programmation des cellules mémoire, les transistors 14 et 15 sont, comme les transistors T et T', des transistors dissymétriques, c'est-à-dire dont les drains respectifs sont formés de caissons N alors que les sources respectives sont des régions classiques. Cela leur permet de tenir la tension lorsque le potentiel d'une des bornes 2 et 2' excède la tension Vdd lors d'un cycle de programmation.

Pendant une programmation, soit la cellule 10, soit la cellule 11 est sélectionnée pour être claquée. Des tensions de commande complémentaires Vsel et NVsel définissent celle des capacités C et C' qui doit être claquée. Le signal Rsel est à la masse afin de bloquer les transistors 14 et 15. Par conséquent, l'étage de lecture est protégé de la haute tension Vprog appliquée sur la borne 13 pendant le cycle de programmation.

Pendant un cycle de lecture, la borne 13 est connectée au potentiel (par exemple, 2,5 V) CMOS standard. Les capacités C et C' sont préchargées au niveau Vdd en appliquant un état haut (Vdd) sur les signaux Vsel et Nvsel. Puis les noeuds 2 et 2' sont laissés flottant en bloquant les transistors T et T' par une commutation vers le niveau bas (la masse) des signaux Vsel et Nvsel. Un courant de fuite circule alors dans l'oxyde du condensateur C ou C' qui a été claqué. Le noeud 2 ou 2' de caisson N correspondant est porté à la tension Vdd tandis qu'il reste à la masse pour la cellule non programmée dont la capacité reste chargée à la tension Vdd. La différence de tension est détectée par les inverseurs couplés 16 et 17 lorsque le potentiel du signal Rsel est porté au potentiel Vdd de façon à rendre passant les transistors 14 et 15.

On notera que, à la place d'un amplificateur de lecture différentiel, on pourra également avoir recours à un amplificateur non différentiel classique. Dans un tel cas, on pourra, par exemple, examiner sur le temps de charge de la capacité C pour détecter si celle-ci est claquée ou non claquée.

Toutefois, un avantage d'un recours à un amplificateur de lecture différentiel tel qu'illustré par la figure 5 est que la lecture ne dépend pas d'éventuelles dispersions technologiques des impédances d'oxyde des capacités claquées.

Quel que soit l'amplificateur de lecture utilisé, on veillera à isoler ce dernier de la cellule lors de la programmation, au moyen de transistors supportant une haute tension (de l'ordre de 10 V), de préférence, des transistors dissymétriques du type de ceux utilisés pour constituer la cellule mémoire.

De préférence, le transfert de la donnée stockée dans la cellule au moyen du signal Rsel lors d'un cycle de lecture s'effectue de façon à transférer la donnée vers un point mémoire volatile (par exemple, un registre) de façon à permettre une dépolarisation des cellules 10 et 11 afin d'augmenter la durée de vie des capacités d'oxyde de grille qui ont été contraintes à moyenne tension pendant la programmation (capacités non claquées mais qui ont subi un vieillissement pendant la programmation).

On notera qu'il n'est pas indispensable que la tension de programmation soit disponible sur le dispositif final. Cela dépend de l'application. Ainsi, dans une application à l'organisation d'un réseau de cellules mémoire pourvu d'éléments de redondance, les éléments défaillant éventuels sont, le plus souvent, détectés lors d'un test électrique en fin de fabrication. Ainsi, la programmation ne s'effectue pas par l'utilisateur. Le circuit intégré fini n'a donc pas besoin de recevoir la tension Vprog dans la mesure où la borne 13 d'alimentation des cellules n'a besoin de recevoir que la tension Vdd (par exemple, 2,5 V) en lecture. Dans une autre application où des cellules mémoire de l'invention sont utilisées au sein d'un circuit mémoire afin de pouvoir être programmées par l'utilisateur (par exemple, dans une mémoire de stockage de paramètres devant être conservés après coupure de l'alimentation), le circuit disposera d'une borne de réception de la tension Vprog.

On notera également que l'adaptation des signaux d'adressage de la cellule que se soit en lecture ou en programmation est à la portée de l'homme du métier. En particulier, on pourra modifier les rampes de programmation de même que l'évolution des signaux de commande en lecture en fonction des applications.

Un avantage de la présente invention est qu'elle permet de réaliser une cellule mémoire à programmation unique qui soit peu coûteuse et relativement peu encombrante. A titre d'exemple particulier de réalisation, on pourra réaliser, en technologie 0,25 µm, une cellule de l'invention sur une surface de l'ordre de 400 µm² pour contenir l'ensemble de la cellule et son amplificateur de lecture.

A titre d'exemple particulier de réalisation, pour une capacité d'une surface de 0,3 µm², et des transistors dissymétriques d'une largeur de grille de 0,5 µm et d'une longueur de grille de 1 µm, le courant de programmation mesuré est de 1mA (ce courant est fixé par la largeur de grille du transistor de programmation). Le courant de lecture est alors de 50 µA avec une tension de grille de 2,5 volts.

On notera que le caisson formant le drain du transistor de programmation dissymétrique peut servir également de caisson à la capacité comme l'illustre la figure 2. On obtient ainsi une solution relativement dense.

Bien entendu, la présente invention est susceptible de diverses variantes et modifications qui apparaîtront à l'homme de l'art. En particulier, les dimensionnements respectifs d'une capacité d'oxyde et d'un transistor de programmation d'une cellule selon la présente invention sont à la portée de l'homme du métier en fonction de l'application et, en particulier, en vue d'obtenir un point d'équilibre satisfaisant pour la cellule mémoire.

De plus, on notera qu'une cellule selon l'invention peut être intégrée dans un réseau de cellules mémoire de type classique, l'organisation de la sélection d'une cellule et sa polarisation étant parfaitement compatibles avec les techniques habituelles.

En outre, bien que l'invention ait été décrite en relation avec un exemple de cellule réalisée avec un transistor de programmation à canal N, la transposition de l'invention à une cellule dont le transistor de programmation est à canal P est à la portée de l'homme du métier à partir des indications fonctionnelles données ci-dessus. Dans ce cas, le substrat est de type N et les caissons des transistors à canal N et les régions de drain des transistors dissymétriques à canal P sont de type P.

## Revendications

1. Cellule mémoire à programmation unique en technologie CMOS, caractérisée en ce qu'elle comprend une capacité (C) associée en série avec un transistor (T) de programmation dissymétrique, dont le drain est formé d'une région plus faiblement dopée et plus épaisse que la source.

2. Cellule selon la revendication 1, caractérisée en ce que ladite association en série est connectée entre deux bornes d'application d'une tension d'alimentation.

3. Cellule selon la revendication 1 ou 2, caractérisée en ce qu'une première électrode (2) de la capacité (C) est constituée par ladite région.

4. Cellule selon l'une quelconques des revendications 1 à 3, caractérisée en ce que ladite capacité (C) est formée dans un niveau d'oxyde (4) constitutif de grilles de transistors.

5. Cellule selon l'une quelconque des revendications 1 à 4, caractérisée en ce qu'une deuxième électrode (1) de la capacité (C) est propre à recevoir, en lecture, un potentiel relativement bas (Vdd) et, en programmation, un potentiel relativement élevé (Vprog).

6. Cellule selon la revendication 5, caractérisée en ce que le transistor (T) et la capacité (C) sont dimensionnés de sorte que, pendant un cycle de programmation et pour une cellule non sélectionnée, la tension aux bornes de la capacité reste inférieure à sa tension de claquage quand les courants dans la capacité et dans le transistor s'équilibrent.

7. Cellule selon la revendication 6, caractérisée en ce que le transistor (T) est dimensionné pour limiter le courant dans une cellule sélectionnée, tout en autorisant un claquage de l'oxyde constitutif de la capacité (C).

8. Procédé de fabrication de cellules mémoire à programmation unique de type anti-fusible en technologie CMOS, caractérisé en ce qu'il consiste à former des régions de drain de transistors de programmation dissymétriques d'un premier type de canal en même temps que des caissons destinés à recevoir entièrement des transistors MOS d'un deuxième type de canal.

9. Procédé selon la revendication 8, caractérisé en ce qu'une capacité associée en série avec chaque transistor de programmation dissymétrique a une première électrode constituée par la région de drain dudit transistor.
